# EUROPEAN PATENT APPLICATION

(11) **EP 4 841 389 A1**
(43) Date of publication of application: **18.11.2026**
(21) Application number: 26178268.4
(22) Date of filing: 12.05.2026
(51) Int. Cl.: G06F 1/16, G09F 9/30, G09F 9/302

(54) **INTEGRATED FRAME AND TRANSPARENT SCREEN**

(30) Priority: 13.05.2025 CN 202520936219 U; 26.06.2025 CN 202510870671; 30.12.2025 WO PCT/CN2025/147588
(71) Applicant: Roe Visual Co Ltd, Shenzhen City, Guangdong 518118 (CN)
(72) Inventor: TIAN, Zhichun, Shenzhen City (CN); LI, Yanjun, Shenzhen City (CN); DAI, Lisheng, Shenzhen City (CN); DENG, Shengyun, Shenzhen City (CN); CHEN, Lei, Shenzhen City (CN)
(74) Representative: Renaudo, Adrien Hanouar

(57) **Abstract**

Embodiments of the present disclosure provide an integrated frame and a transparent screen. The transparent screen includes an integrated frame and a transparent display screen body being located at a side of the integrated frame. The integrated frame includes a frame body, a power board and an adapter board. The power board, the display screen body and the adapter board are coupled in pairs. The frame body includes a plurality of side frames connected end to end in sequence. The side frames are not protruding from an edge where the display screen body is in contact with the side frames, which will not block the display surface of the display screen body, ensuring the transparency of the transparent screen. And it can also make the volume of the frame smaller and make the appearance simpler and more beautiful.

## Description

### FIELD

The present disclosure relates to the field of display screen device technology, particularly to an integrated frame and a transparent screen.

### BACKGROUND

In the design of traditional transparent display screens, in order to make the layout of internal assembly reasonably, the power box is usually placed on the back of the display screen integrated frame, to effectively utilize the space on the back of the display screen. However, for transparent display screens, if the battery or power board is still placed on the back of the display screen integrated frame, it will cause obstruction to the transparent display screen and affect its transparency.

### SUMMARY

In view of the above problems, embodiments of the present disclosure are proposed. The aim of the embodiments of the present disclosure is to provide an integrated frame that can integrate the power board together without blocking the transparent screen.

To achieve this purpose, the following technical solutions are adopted in the embodiments of the present disclosure:
an integrated frame, with a display screen body arranged on one side of the integrated frame, wherein the integrated frame includes:
a frame body, comprising a plurality of side frames connected end to end in sequence, where the side frames are not protruding from an edge where the display screen body is in contact with the side frames;
a power board, being coupled to the display screen body; and
an adapter board, being coupled to both the power board and the display screen body, wherein the power board and the adapter board are arranged inside the side frames respectively.

Optionally, the side frames are provided an accommodation groove, and both the power board and the adapter board are provided at least one;
the power board or the adapter board is accommodated one-to-one with the accommodation groove, or the power board and the adapter board are accommodated in one accommodation groove at the same time.

Optionally, a side of the side frames facing the display screen body is provided with a wire accommodation groove, the wire accommodation groove is in communication with the accommodation groove, and a coupling wire is accommodated in the wire accommodation groove.

Optionally, along a direction perpendicular to the display screen body, a size of the side frames located at the accommodation groove is larger than a width of the power board or the adapter board.

Optionally,
the accommodation groove is located on a side of the side frames facing an inner side of the integrated frame; or
the accommodation groove is located on a side of the side frames facing an outer side of the integrated frame; or
the accommodation groove is located inside the side frames; or
the accommodation groove is located on a side of the side frames facing the display screen body; or
the accommodation groove is located on a side of the side frames away the display screen body.

Optionally, further including:
a cover plate, being covered at an opening of the accommodation groove.

Optionally, the power board and the adapter board are located at different side frames.

Optionally, further including:
a power output connector and a power input connector matching each other, and a signal output connector and a signal input connector matching each other;
both the power output connector and the power input connector are coupled to the power board;
both the signal output connector and the signal input connector are coupled to the adapter board;
the power output connector and the power input connector are located two ends of the side frames respectively;
the signal output connector and the signal input connector are located two ends of the side frames respectively;
the side frame being provided with the power output connector or the power input connector is arranged opposite to the side frame being provided with signal output connector or the signal input connector.

Optionally, the integrated frame is integrally formed and is made of metal material.

Optionally, the plurality of side frames comprises one first side frame and a plurality of second side frames;
the adapter board is arranged inside the first side frame;
the power board is disassembled into a plurality of power modules being coupled together, and each of the second side frames is provided with at least one power module.

Optionally, the plurality of side frames is connected end to end in sequence, to enclose the frame body with a hollow interior, a side of the display screen body away from a display surface of the display screen body is free from a support rod, a grille and other rod members connected on the side frames.

Optionally, the display screen body includes one lamp panel, an outer edge of the lamp panel away from its display surface is connected to the frame body.

Optionally, the display screen body includes at least two lamp panels being tiled and spliced together and being connected to the side frames, and a surface of the display screen body away from its display surface is provided a plurality of connection plates;
the connection plates are provided at a splicing seam of two lamp panels and are used to connect two adjacent lamp panels together.

Optionally, a surface of the lamp panel away from the side frames is provided with a plurality of LED light beads being arranged in an array, the lamp panel is further provided with a plurality of first light-transmitting holes, the first light-transmitting holes are arranged inside a clearance of at least two LED light beads;
the connection plate is provided with a second light-transmitting hole with a location corresponding to and a size same with the first light-transmitting hole on two sides of the splicing seam.

Optionally, a VHB adhesive layer is provided between the lamp panel and the connection plate, and two opposite surfaces of the VHB adhesive layer are adhered with the lamp panel and the connection plate respectively;
the VHB adhesive layer is provided with a third light-transmitting hole with a location corresponding to and a size same with the first light-transmitting hole on two sides of the splicing seam.

Optionally, two sides of the splicing seam on a surface of the lamp panel away from the LED light beads are provided with a sinking groove for accommodating the connection plate and the VHB adhesive layer, so that a surface of the connection plate away from the VHB adhesive layer is flush with a surface of the lamp panel away from the LED light beads.

Optionally, the frame body further includes a plurality of adapter corners, the adapter corners are provided between two adjacent side frames, to connect the two adjacent side frames together;
the adapter corners have a mounting portion extending towards a center of the frame body, and the mounting portion is used to mount a power connector and/or a signal connector;
wherein, a size of the power connector and the signal connector on a display surface direction of the display screen body is greater than a width of the side frames.

Optionally, a surface of the display screen body away from the side frames comprises an arear being attached with the side frames, a plurality of LED light beads is arranged in the area in an array.

Optionally, the display screen body includes at least two lamp panels;
the first side frame is provided with one adapter board, and along a length direction of the adapter board, at least two electrical connectors being coupled to two lamp panels respectively are provided.

Optionally, the display screen body includes at least two lamp panels;
at least two adapter boards coupled together are provided inside the first side frame, each adapter board is provided the electrical connector coupled to one lamp panel.

Another aim of the embodiments of the present disclosure is to provide a transparent screen with a power box not affect the transparency.

To achieve this purpose, the following technical solutions are adopted in the embodiments of the present disclosure:

A transparent screen, including:
an integrated frame and a transparent display screen body being located at a side of the integrated frame; where,
the transparent display screen body is coupled with the integrated frame, and the integrated frame includes:
   a frame body, comprising a plurality of side frames connected end to end in sequence, wherein the side frames are not protruding from an edge where the display screen body is in contact with the side frames;
   a power board, being coupled to the display screen body; and
   an adapter board, being coupled to both the power board and the display screen body, where the power board and the adapter board are arranged inside the side frames respectively.

Optionally, the side frames are provided an accommodation groove, and both the power board and the adapter board are provided at least one;
the power board or the adapter board is accommodated one-to-one with the accommodation groove, or the power board and the adapter board are accommodated in one accommodation groove at the same time.

Optionally, a side of the side frames facing the display screen body is provided with a wire accommodation groove, the wire accommodation groove is in communication with the accommodation groove, and a coupling wire is accommodated in the wire accommodation groove.

Optionally, along a direction perpendicular to the display screen body, a size of the side frames located at the accommodation groove is larger than a width of the power board or the adapter board.

Optionally,
the accommodation groove is located on a side of the side frames facing an inner side of the integrated frame; or
the accommodation groove is located on a side of the side frames facing an outer side of the integrated frame; or
the accommodation groove is located inside the side frames; or
the accommodation groove is located on a side of the side frames facing the display screen body; or
the accommodation groove is located on a side of the side frames away the display screen body.

Optionally, further including:
a cover plate, being covered at an opening of the accommodation groove.

Optionally, the power board and the adapter board are located at different side frames.

Optionally, further including:
a power output connector and a power input connector matching each other, and a signal output connector and a signal input connector matching each other;
both the power output connector and the power input connector are coupled to the power board;
both the signal output connector and the signal input connector are coupled to the adapter board;
the power output connector and the power input connector are located two ends of the side frames respectively;
the signal output connector and the signal input connector are located two ends of the side frames respectively;
the side frame being provided with the power output connector or the power input connector is arranged opposite to the side frame being provided with signal output connector or the signal input connector.

Optionally, the integrated frame is integrally formed and is made of metal material.

Optionally, the plurality of side frames comprises one first side frame and a plurality of second side frames;
the adapter board is arranged inside the first side frame;
the power board is disassembled into a plurality of power modules being coupled together, and each of the second side frames is provided with at least one power module.

Optionally, the plurality of side frames is connected end to end in sequence, to enclose the frame body with a hollow interior, a side of the display screen body away from a display surface of the display screen body is free from a support rod, a grille and other rod members connected on the side frames.

Optionally, the display screen body includes one lamp panel, an outer edge of the lamp panel away from its display surface is connected to the frame body.

Optionally, the display screen body includes at least two lamp panels being tiled and spliced together and being connected to the side frames, and a surface of the display screen body away from its display surface is provided a plurality of connection plates;
the connection plates are provided at a splicing seam of two lamp panels and are used to connect two adjacent lamp panels together.

Optionally, a surface of the lamp panel away from the side frames is provided with a plurality of LED light beads being arranged in an array, the lamp panel is further provided with a plurality of first light-transmitting holes, the first light-transmitting holes are arranged inside a clearance of at least two LED light beads;
the connection plate is provided with a second light-transmitting hole with a location corresponding to and a size same with the first light-transmitting hole on two sides of the splicing seam.

Optionally, a VHB adhesive layer is provided between the lamp panel and the connection plate, and two opposite surfaces of the VHB adhesive layer are adhered with the lamp panel and the connection plate respectively;
the VHB adhesive layer is provided with a third light-transmitting hole with a location corresponding to and a size same with the first light-transmitting hole on two sides of the splicing seam.

Optionally, two sides of the splicing seam on a surface of the lamp panel away from the LED light beads are provided with a sinking groove for accommodating the connection plate and the VHB adhesive layer, so that a surface of the connection plate away from the VHB adhesive layer is flush with a surface of the lamp panel away from the LED light beads.

Optionally, the frame body further includes a plurality of adapter corners, the adapter corners are provided between two adjacent side frames, to connect the two adjacent side frames together;
the adapter corners have a mounting portion extending towards a center of the frame body, and the mounting portion is used to mount a power connector and/or a signal connector;
wherein, a size of the power connector and the signal connector on a display surface direction of the display screen body is greater than a width of the side frames.

Optionally, a surface of the display screen body away from the side frames comprises an arear being attached with the side frames, a plurality of LED light beads is arranged in the area in an array.

Optionally, the display screen body includes at least two lamp panels;
the first side frame is provided with one adapter board, and along a length direction of the adapter board, at least two electrical connectors being coupled to two lamp panels respectively are provided.

Optionally, the display screen body includes at least two lamp panels;
at least two adapter boards coupled together are provided inside the first side frame, each adapter board is provided the electrical connector coupled to one lamp panel.

The technical solution provided by the embodiments of the present disclosure, by integrating the power board and the adapter board into the side frame of the integrated frame and setting the side frame not to protrude from the edge where the display screen body is in contact with the side frame, not only reduces the space of the individual power box, making the frame smaller in volume and the surface more simple and beautiful, but also avoids blocking the display surface of the display screen. Thus, when the display screen is a transparent one, it will not affect the transparency of the transparent screen.

### BRIEF DESCRIPTION OF THE DRAWINGS

In order to describe the embodiments of the present disclosure or the technical solutions in the prior art more clearly, drawings required to be used in the embodiments or the description of the prior art will be briefly introduced below. Apparently, the drawings in the description below are some embodiments of the present disclosure. Those of ordinary skill in the art may also obtain other drawings according to the provided drawings without involving any inventive effort.
FIG. 1 is a structural schematic diagram of an integrated framework according to embodiments of the present disclosure;
FIG. 2 is a partial explosion view of an integrated framework according to embodiments of the present disclosure;
FIG. 3 is a three-dimensional structure explosion schematic diagram of a transparent screen according to embodiments of the present disclosure;
FIG. 4 is an enlarged view of Part A in FIG. 3;
FIG. 5 is a schematic diagram of the explosion of the three-dimensional structure of two lamp panels of the transparent screen after being spliced and connected to the connection plate according to embodiments of the present disclosure; and
FIG. 6 is a side structure schematic diagram of the frame body of the integrated frame according to embodiments of the present disclosure.

### DETAILED DESCRIPTION OF EXAMPLE EMBODIMENTS

Under normal circumstances, the display screen body is equipped with a power box. Inside the power box, there is a power board and an adapter board. The power board, the adapter board and the display screen body are coupled in pairs. The power board can stabilize the voltage and convert the 220v AC power to the voltage required by the display screen, while the adapter board can optimize the signal transmission to ensure the signal quality and stability. The power box is usually set as a separate electrical component in the center of the display screen frame, located at the back of the display surface of the display screen. However, if the display screen is a transparent one, due to the projection of the power box on the display plane of the display screen, it will cause obstruction to the transparent display screen, resulting in poor transparency of the transparent display screen.

However, the transparent display screen body must be supported by a frame to have sufficient strength, so as not to be easily damaged and to be spliced together with other transparent display screen bodies to form a large screen. Based on this, the inventor of the present disclosure starting from the connection structure between the transparent display screen body and the frame and attempting to integrate the power box into the frame, to make the frame an integrated frame capable of voltage conversion and signal transmission, has conducted continuous research and obtained various embodiments of the present disclosure.

The present disclosure will be further described in detail with reference to the accompanying drawings and embodiments. It can be understood that the specific embodiments described here are only for explaining the present disclosure, and not for limiting the present disclosure. Additionally, it should be noted that for ease of description, only a portion related to the present disclosure is shown in the accompanying drawings, rather than the entire structure.

In the description of the present disclosure, unless otherwise specified and limited, the terms "connected", "connecting", and "fixed" should be broadly understood, for example, they can be fixed connections, detachable connections, or integrated; it can be a mechanical connection or an electrical connection; it can be directly connected or indirectly connected through an intermediate medium, and it can be a connection within two assemblies or an interaction relationship between two assemblies. For ordinary technical personnel in this field, the specific meanings of the above terms in the present disclosure can be understood in specific situations.

In the present disclosure, unless otherwise specified and limited, the first feature "above" or "below" the second feature may include direct contact between the first and second features, or may include contact between the first and second features through another feature between them instead of direct contact. Moreover, the first feature being "above", "over", and "up" the second feature includes the first feature being directly above and diagonally above the second feature, or simply indicating that the first feature is horizontally higher than the second feature. The first feature being "below", "under", and "underneath" include the first feature being directly below and diagonally below the second feature, or simply indicating that the first feature has a lower horizontal height than the second feature.

In the description of this embodiment, the terms "up", "down", "right", etc. are based on the orientation or position relationship shown in the accompanying drawings, only for the convenience of description and simplification of operation, and do not indicate or imply that the device or element referred to must have a specific orientation, be constructed and operated in a specific orientation, and therefore cannot be understood as a limitation of the present disclosure. In addition, the terms "first" and "second" are only used to distinguish in description and do not have any special meaning.

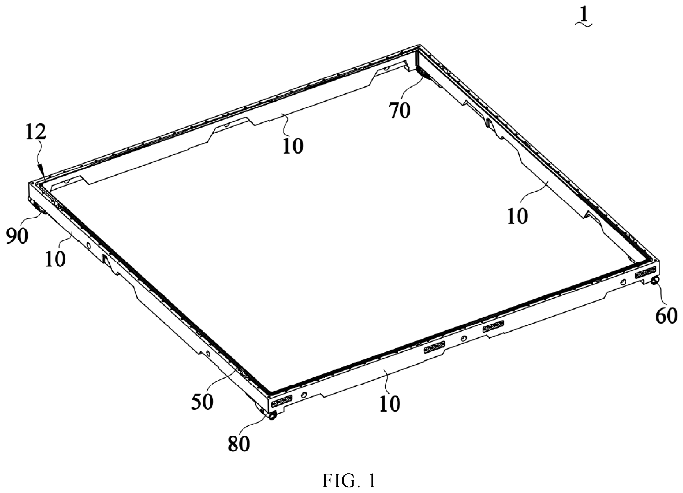

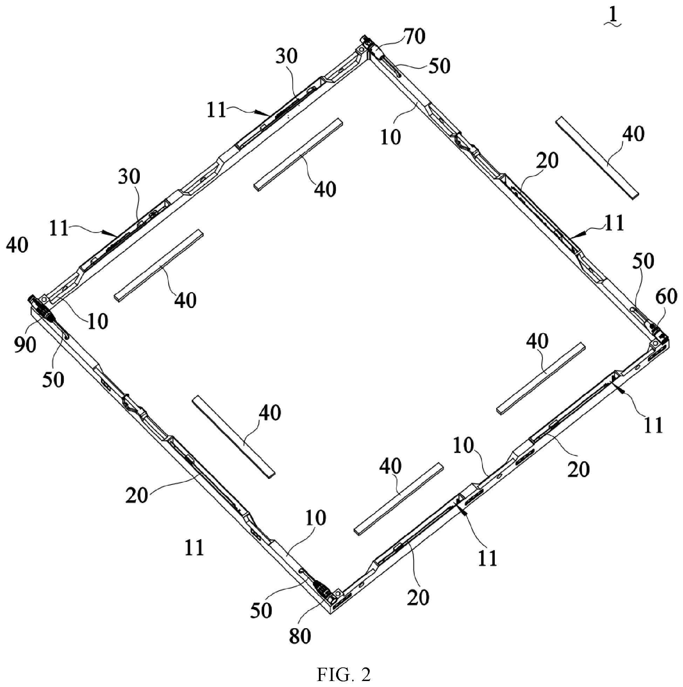

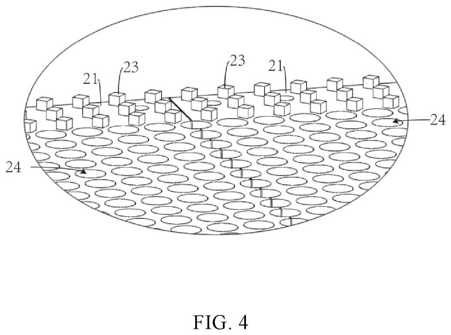

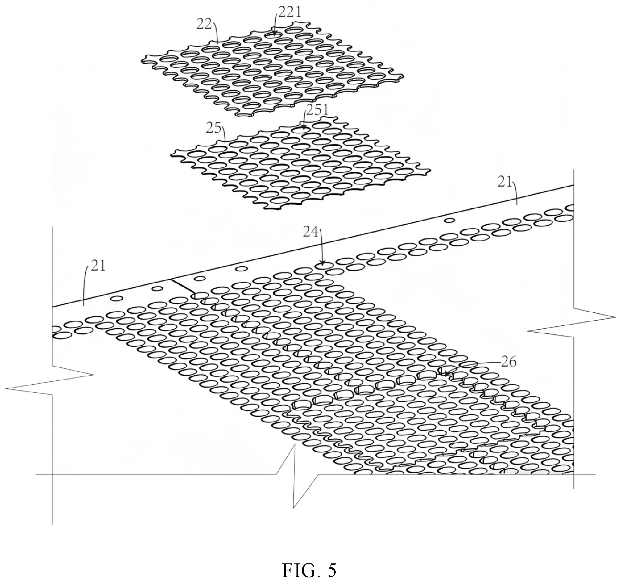

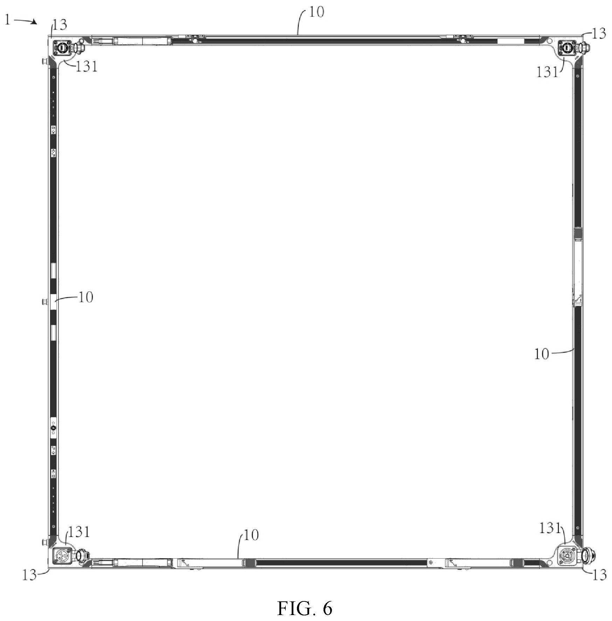

Please refer to FIGs. 1 to 6, the present disclosure provides an integrated frame 1, the integrated frame 1 comprises a frame body, a power board 20 and an adapter board 30. The frame body includes a plurality of side frames 10 connected end to end in sequence, and the circumferential edge of the back of the display screen body 2 is lapped with one side of the side frames 10. The embodiments of the present disclosure also provide a transparent screen, which comprises an integrated frame 1 and a display screen body 2 located on a side of the integrated frame 1. The display screen body 2 is a transparent display screen body, and the transparent display screen body is coupled with the integrated frame 1. The transparent display screen body referred to here means that the screen body is made of transparent material. Transparent materials include polyester film (PET), polycarbonate (PC), glass substrate, polyimide (PI) film and PMMA (acrylic), etc. Alternatively, it can be made of opaque materials with large areas of light-transmitting holes set on the screen body to achieve a transparent effect, or it can be made of transparent materials with large areas of light-transmitting holes set on the screen body to achieve a transparent effect.

Specifically, the power board 20, the adapter board 30 and the display screen body 2 are coupled in pairs, to ensure the normal operation of the display screen body 2. The power board 20 and the adapter board 30 are respectively arranged inside the side frame 10. If the side frame does not protrude from the edge where the display screen body 2 is in contact with the side frame, then the lap edge of the display screen body 2 at the display surface can cover the side frame 10. Since the side frame 10 will not protrude from the lap edge, it will not cover the display surface of the transparent display screen, ensuring the transparency of the transparent display screen.

It should be noted that the side frame 10 here does not include the connecting lock and handle arranged on the side frame 10. The connection lock here is used to lock two adjacent side frames 10. The handle here can be a component providing a gripper for the side frame 10 or an operating component of the connection lock. The connection lock and the handle can be completely hidden within the side frame 10 or on the surface of the side frame 10 away from the display surface, so that the display screen is transparent and unobstructed. The connection lock and the handle can also be partially protruding from the side frame 10. Compared with the large display surface, the volume protruding from the side frame 10 is smaller, and the impact on the transparency of the display screen is relatively small. The connection lock and the handle may also extend out of the side frame 10 in a certain state, for example, when the two side frames 10 are disconnected, part of the connection lock and the handle extend out of the side frame 10, but when the two side frames 10 are locked and connected, they are completely hidden within the side frame 10 or on the surface of the side frame 10 away from the display surface, to ensure no impact on the transparency of the display screen.

Integrating the power board 20 and the adapter board 30 into the frame to form an integrated frame 1 can simplify the appearance of the frame, making the display screen frame more aesthetically pleasing, occupying less space and being easier to store.

Referring to FIGs. 1 to 2, the integrated frame 1 provided by the embodiments of the present disclosure is not limited to application on transparent display screens, but can also be applied to ordinary display screens, as long as the supporting strength of the display screen is met.

With the development of display screen technology and the improvement of modern aesthetic concepts, the shape of display screens is no longer limited to rectangles. Currently, triangular display screens, trapezoidal display screens, hexagonal display screens, and so on have emerged. Therefore, in order to meet the support requirements of display screens of different shapes, please refer to FIGs. 1 to 2, the number of side frames 10 of the integrated frame 1 in the embodiment of the present disclosure corresponds one-to-one with the number of side edges of the display screen, and the edge at each side edge on the side surface of the display screen away from the display surface corresponds to one side frame 10, thereby ensuring the stability and strength of the support.

Please referring to FIGs. 1 to 2, in some embodiments of the present disclosure, the side frame 10 is provided with an accommodation groove 11, and both the power board 20 and the adapter board 30 are placed in the accommodation groove 11, thereby being isolated from the outside world to protect the power board 20 and the adapter board 30 from damage by the outside world. The power board 20 and the adapter board 30 can be simultaneously accommodated in one accommodation groove 11, to reduce the length of the coupling wire 50. However, when a plurality of transparent display screen bodies 2 is spliced together to form a transparent screen, in order to ensure a good transparent display effect of the transparent screen, usually the edges of the transparent display screen body 2 used to overlap with the frame in the circumferential direction are relatively narrow, and thus the side frame 10 will also be relatively narrow. Then, the accommodation groove 11 on the side frame 10 is difficult to accommodate both the power board 20 and the adapter board 30 in one accommodation groove 11. Moreover, if the power board 20 and the adapter board 30 are placed in one accommodation groove 11 in close contact, it will also cause interference to the signal, affecting the quality and stability of the signal. Therefore, in some embodiments of the present disclosure, at least one accommodation groove 11 is provided on the side frame 10, and the power board 20 or the adapter board 30 is arranged one-to-one with the accommodation groove 11. When there are more than two accommodation grooves 11 on the side frame 10, the power board 20 and the adapter board 30 can be set in different accommodation grooves 11 on the same side frame 10. Since there must be a certain distance between the two accommodation grooves 11, there must be a distance between the power board 20 and the adapter board 30, thereby avoiding signal interference. Moreover, since the power board 20 and the adapter board 30 are both located on the same side frame 10, compared with those on different side frames 10, the length of the coupling wire 50 between them is relatively short, thus saving the material used for the coupling wire.

It is understandable that if one display screen uses only one power board 20 and one adapter board 30, it will result in insufficient power supply and poor power stability. Multiple signals sharing one adapter board 30 may cause signal interference or attenuation. Therefore, under normal circumstances, the power box of the display screen is equipped with multiple power boards 20 and multiple adapter boards 30. Please refer to FIGs. 1 to 2, in the embodiments of the present disclosure, since there are multiple side frames 10, multiple power boards 20 and adapter boards 30 can be distributed and accommodated in different side frames 10, so that the integrated frame 1 of the embodiments of the present disclosure can also include multiple power boards 20 and multiple adapter boards 30. In this case, to ensure better signal stability, in some embodiments of the present disclosure, the adapter board 30 and the power board 20 are respectively placed in the accommodation grooves 11 of different side frames 10, which increases the distance between the adapter board 30 and the power board 20 and avoids electromagnetic interference to the adapter board 30. When multiple accommodation grooves 11 are provided on the side frame 10, different adapter boards 30 are located on the same side frame 10, and different power boards 20 are located on the same side frame 10, and the side frame 10 where the adapter board 30 is located is adjacent to the side frame 10 where the power board 20 is located, in order to reduce the length of the coupling wire 50 between the adapter board 30 and the power board 20, reducing costs accordingly. Since the control signal of the display screen body 2 is relatively simple, while the electrical energy required by the display screen to ensure sufficient brightness is relatively large, in the embodiment of the present disclosure, the number of power boards 20 is more than that of the adapter boards 30. There are 4 power boards 20 and 2 adapter boards 30. The side frames 10 on both the left and right sides of the display screen body 2 are both provided with two accommodation grooves 11 at intervals, with two accommodation grooves 11 on one side frame 10 accommodating only the adapter board 30, while two accommodation grooves 11 on the other side frame 10 accommodating only the power board 20. The side frames 10 located on both the upper and lower sides of the display screen body 2 are both provided with one accommodation groove 11, respectively accommodating two other power boards 20. This way, it can not only ensure that the distance between the power board 20 and the adapter board 30 does not cause interference to the signal, but also ensure that the length of the coupling wire 50 between the power board 20 and the adapter board 30 is as short as possible to reduce costs.

Please refer to FIGs. 1 to 2, in some embodiments of the present disclosure, a wire accommodating groove 12 is provided on the side of the side frame 10 facing the display screen body 2. The wire accommodating groove 12 is in communication with the accommodating groove 11, and the coupling wire 50 is placed in the wire accommodating groove 12. Not only can the structure of the side frame 10 be fully utilized for wiring, allowing the side frame 10 to have more space for setting components such as screen connection locks and lock grooves, but it can also avoid wiring inside the side frame 10, simplifying the manufacturing and assembly difficulties.

A transparent display screen composed of multiple transparent screens is usually controlled by one controller for the displayed images and one main power switch to control the cut-off or supply of electrical energy. Therefore, adjacent transparent screens need to be coupled together. Therefore, as shown in FIGs. 1 to 2, in some embodiments of the present disclosure, the integrated frame 1 further includes a power output connector 70 and a power input connector 60 matching each other, and a signal output connector 90 and a signal input connector 80 matching each other, wherein both the power output connector 70 and the power input connector 60 are coupled to the power board 20. Both the signal output connector 90 and the signal input connector 80 are coupled to the adapter board 30. To facilitate the coupling of two adjacent transparent screens, the power output connector 70 and the power input connector 60 are respectively located at two ends of one side frame 10, and the signal output connector 90 and the signal input connector 80 are respectively located at two ends of another side frame 10. The side frame 10 where the power output connector 70 or the power input connector 60 is located is set opposite to the side frame 10 where the signal output connector 90 or the signal input connector 80 is located. One side frame 10 is located above the display screen, and the other side frame 10 is located below the display screen. In this way, when two adjacent transparent screens are connected, the signal input connector 80 of the previous transparent screen is exactly plugged into the signal output connector 90 of the next transparent screen, and at the same time, the power input connector 60 of the previous transparent screen is exactly plugged into the power output connector 70 of the next transparent screen. Please continue to refer to FIG. 1, in the embodiments of the present disclosure, since both the power output connector 70 and the power input connector 60 occupy the space of the side frame 10, only one accommodation groove 11 can be provided on the side frame 10 above the display screen to accommodate the power board 20. Similarly, since both the signal output connector 90 and the signal input connector 80 occupy the space of the side frame 10, only one accommodation groove 11 can be provided on the side frame 10 below the display screen to accommodate the power board 20.

It is understandable that both the power board 20 and the adapter board 30 have a certain width to accommodate the installation of different electronic components. To accommodate the power board 20 and the adapter board 30, the size of the side frame 10 in the direction perpendicular to the display screen body 2 must be greater than the width of the power board 20 or the adapter board 30, which results in a relatively large size of the side frame 10, and the problem of being relatively heavy. Therefore, please refer to FIGs. 1 to 2, in some embodiments of the present disclosure, along the direction perpendicular to the display screen body 2, the size at the accommodation groove 11 on the side frame 10 is greater than the width of the power board 20 or the adapter board 30, to ensure the installation of the power board 20 or the adapter board 30, while the sizes at other positions can be smaller than those of the power board 20 and the adapter board 30, as long as the supporting strength is sufficient, the material used for the side frame 10 can be reduced, and the weight of the side frame 10 can be decreased, thereby lowering the overall weight of the transparent screen. In this way, when the transparent screen composed of multiple transparent screens spliced in sequence is a vertically upright screen, the transparent screen at the bottom will have sufficient strength to bear the weight of the transparent screen at the top, ensuring the stability of the entire transparent screen.

For the convenience of installing the power board 20 or the adapter board 30, please refer to FIGs. 1 to 2, in some embodiments of the present disclosure, the integrated frame 1 further includes a cover plate 40, and an opening is formed on the accommodation groove 11. The cover plate 40 is arranged at the opening to seal or open the opening. When the opening is opened, it is convenient to insert the power board 20 or the adapter board 30. When the opening is blocked by the cover plate 40, the power board 20 and the adapter board 30 can be isolated from the outside world.

In some embodiments of the present disclosure, the position of the accommodation groove 11 can be located on the side of the side frame 10 facing the integrated frame 1, with the opening facing the inner of the integrated frame 1. Alternatively, the accommodation groove 11 can be located a side facing the outside of the integrated frame 1, with the opening facing the outside of the integrated frame. Alternatively, the accommodation groove is located inside the side frame. In this case, the accommodation groove can be located on a side of the side frame facing the display screen body 2, or located on the side of the side frame away from the display screen body 2. In this case, the opening faces the side away from the display screen body 2. The position of the accommodation groove can be set according to actual needs and the convenience of operation. In this regard, the present disclosure does not make specific limitations. It is understandable that the position of the accommodation groove determines the installation position of the power board 20 and the adapter board 30 on the side frame.

It is understandable that if the power board 20 or the adapter board 30 is directly placed in the accommodation groove 11, since the accommodation groove 11 needs to reserve installation space, the size of the groove body of the accommodation groove 11 should be slightly larger than that of the power board 20 or the adapter board 30. This will cause the power board 20 or the adapter board 30 to shake inside the accommodation groove 11. For this purpose, please refer to FIGs. 1 to 2, in some embodiments of the present disclosure, the power board 20 or the adapter board 30 is connected to one of the groove walls of the accommodating groove 11 inner circumference. The connection method can be either screw connection or adhesive connection. For example, when the side surface of the power board 20 and the adapter board 30 perpendicular to the display screen is connected to the groove wall of the accommodating groove 11, a screw can be screwed in on the outside of the side frame 10. The screw passes through the groove wall of the accommodating groove 11 and is screwed onto the power board 20, to achieve the fixation of the power board 20. For another example, when the upper or lower side surface of the power board 20 is connected to the groove wall of the accommodating groove 11, it can be fixed by adhesive.

Therefore, the power board 20 or the adapter board 30 can be adhered to any one of the top, bottom, left or right sides of the accommodation groove 11. Please refer to FIGs. 1 to 2, in the embodiments of the present disclosure, the integrated frame 1 is integrally formed and made of metal material, which not only facilitates the manufacturing of the integrated frame 1, but also the metal has good thermal conductivity. This enables the adapter board 30 or power board 20 to have good heat dissipation, ensuring stable operation.

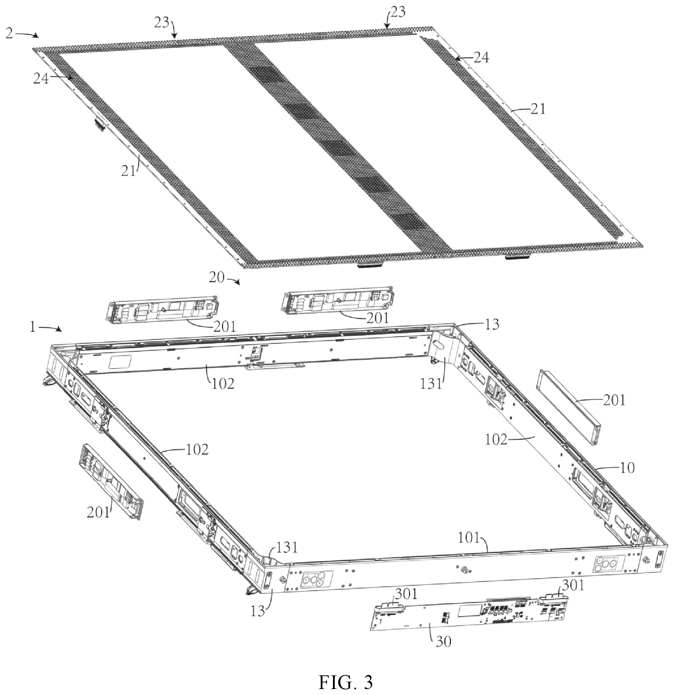

Please refer to FIGs. 3 to 6, in the embodiments of the present disclosure, the plurality of side frames comprises one first side frame 101 and a plurality of second side frames 102;
the adapter board 30 is arranged inside the first side frame 101;
the power board 20 is disassembled into a plurality of power modules 201 being coupled together, and each of the second side frames 102 is provided with at least one power module 201.

Specifically, one first side frame 101 and multiple second side frames 102 are connected end to end in sequence, forming a quadrilateral or other polygonal structure. Within the first side frame 101, an adapter board 30 is provided, the adapter board 30 is a circuit board for control signals and is coupled to the external control circuit and the display screen body 2, used to receive control signals to control the display screen body 2. The power board 20 is arranged in the other side frames 10 other than the first side frame 101, that is, in multiple second side frames 102. The power board 20 described here is used to store electrical energy and supply power to the display screen body 2. To ensure that the display screen body 2 has a good display effect and a relative long display battery life, the power board 20 is required to have a relatively large capacity. Therefore, the total capacity of the power board 20 is generally large, and correspondingly, its volume will also be relatively large. If the power board 20 is arranged within one side frame 10, it will inevitably increase the thickness of said side frame 10. And when the display screen body 2 is a transparent display screen body, the relatively wide and thick side frame 10 will inevitably affect the transparency of the entire display surface, resulting in a poor display effect. Therefore, in the embodiment of the present disclosure, the power board 20 is split into multiple power modules 201, and at least one power module 201 is provided in each second side frame 102. These power modules 201 are coupled together, which enables having a large capacity when supplying power to the display screen body 2, while the volume of a single power module 201 is not too large, which allows the thickness of the side frame 10 that accommodates it to be extremely narrow, without affecting the transparency of the displayed image when the display screen body 2 is a transparent screen. In this embodiment, by splitting the power board 20 into multiple power modules 201, the thickness of the side frame 10 that accommodates the power board 20 can be greatly reduced, resulting in an extremely narrow bezel effect. This significantly enhances the transparency of the transparent display screen and thereby improves the user experience of the transparent display screen.

In other preferred embodiments of the present disclosure, multiple side frames 10 are connected end to end in sequence enclosing a frame body with a hollow interior. On the side of the display screen body 2 away from its display surface, it is free from a support rod, a grille and other rod members connected on the side frames.

Specifically, after multiple side frames 10 are connected end to end in sequence to form the frame body, no support rods, grilles or other rods members for connecting the side frames 10 need to be set inside the frame body. That is, the interior of the frame body is a hollow structure. That is to say, there is no more obstructions, except for one circle of the side frames 10, to the surface of the display screen body 2 away from its display surface, making its transparent display screen has the greatest possible transparency, further enhancing the user experience of the transparent display screen.

In other preferred embodiments of the present disclosure, the display screen body 2 includes one lamp panel 21, an outer edge of the lamp panel 21 away from its display surface is connected to the frame body.

Here, one lamp panel 21 is chosen to be laid flat and fully spread on the frame body instead of multiple ones, because when one lamp panel 21 is coupled with the power board 20 and the adapter board 30 inside the frame body, the number of required connectors is the least, and fewer connectors require less accommodation space for the side frame 10, which will inevitably be conducive to the formation of the side frame 10 with extremely narrow bezels, thereby enhancing the transparency of the transparent display screen and improving the user experience of the transparent display screen.

Furthermore, the surface of the display screen body 2 away from the side frame 10 includes an area where the display screen body 2 is in contact with the side frame 10, multiple LED light beads 23 are arranged in an array in said area.

Specifically, multiple LED light beads 23 are arranged in an array on the surface of the display screen body 2 away from the side frame 10. For illustrative demonstration purposes, only the LED light beads 23 in the upper and lower areas of the lamp panel 21 are drawn in the drawings. In actual use, the LED light beads 23 spread all over the lamp panel 21, including the white area in the drawings, to form the display surface. It also includes that in the area where the display screen body 2 is in contact with the side frame 10, multiple LED light beads 23 are also arranged in an array. That is, in the outer edge area of the display screen body 2, multiple LED light beads 23 are also arranged in an array. Thus, when multiple display screen bodies 2 are assembled, there will be no light or dark lines at the assembly seams, effectively enhance the display effect.

In preferred embodiments, the arrangement densities of the LED beads 23 of the outer edge of the display screen body 2, i.e., the area covering above the side frame 10 and the interior of the display screen body 2, i.e., the hollow area without covering the frame body are the same, which can make the display screen body 2 have a relatively uniform display surface, thereby improving the display effect of the display screen body 2.

In one of the preferred embodiments of the present disclosure, the display screen body 2 includes at least two lamp panels 21;
one adapter board 30 is provided inside the first side frame 101, and along the length direction of the adapter board 30, at least two electrical connectors 301 being respectively coupled to the at least two lamp panels 21 are provided.

Specifically, the display screen body 2 is composed of at least two of the said lamp panels 21 being laid flat and spliced in sequence, and the adapter board 30 is arranged in the side frame 10 perpendicular to the splicing seam of the two said lamp panels 21, that is, in the first side frame 101 as shown in the drawings. Along the length direction of the said adapter board 30, at least two electrical connectors 301 being respectively coupled to the at least two lamp panels 21 are provided, to ensure that the adapter board 30 transmits control signals to the at least two lamp panels 21.

In other preferred embodiments of the present disclosure, the display screen body comprises at least two lamp panels 21;
at least two adapter boards 30 coupling together are provided inside the first side frame 101, and each adapter board 30 is provided with one electrical connector 301 being coupled to the lamp board 21.

Specifically, the display screen body 2 is composed of at least two of the said lamp boards 21 being laid flat and spliced in sequence, and the adapter board 30 is also arranged in the side frame 10 that is perpendicular to the splicing seam of the two said lamp boards 21, that is, in the first side frame 101 as shown in the drawing, but at least two said adapter boards 30 are arranged in the first side frame 101. These adapter boards 30 are coupled together so that each of them can receive control signals. Each adapter board 30 is provided with one electrical connector 301 being coupled to the lamp boards 21, to ensure that each adapter board 30 transmits control signals to the corresponding lamp board 21.

In other preferred embodiments of the present disclosure, the display screen body 2 comprises at least two flat and spliced lamp boards 21 connected to the side frame 10, and the surface of the display screen body 2 away from its display surface is provided with multiple connection plates 22;
the connection plates 22 are provided at a splicing seam of two lamp panels 21 and are used to connect two adjacent lamp panels 21 together.

Specifically, when two adjacent lamp boards 21 are spliced together, the edges of the lamp boards 21 located at two ends of the splicing seam are connected to the side frame 10. When the splicing seam has a relatively large length, the two lamp boards 21 located at the middle position of the splicing seam may deform due to deflection, resulting in a certain height difference between the two adjacent lamp boards 21 and thus being displayed in a staggered manner. By setting multiple connection plates 22 respectively along the length direction of the said splicing seam on the two said lamp boards 21, the adjacent two said lamp boards 21 are tightly connected together, to avoid height differences and staggered display, thereby effectively improving the display effect of the display screen body 2.

Furthermore, a surface of the lamp panel 21 away from the side frames 10 is provided with a plurality of LED light beads 23 being arranged in an array, the lamp panel 21 is further provided with a plurality of first light-transmitting holes 24, the first light-transmitting holes 24 are arranged inside a clearance of at least two LED light beads 23;
the connection plate 22 is provided with a second light-transmitting hole 221 with a location corresponding to and a size same with the first light-transmitting hole 24 on two sides of the splicing seam.

Here, multiple LED light beads 23 and multiple first light-transmitting holes 24 are arranged in an array. As mentioned above, the LED light beads 23 cover the entire lamp board 21, and the first light-transmitting holes 24 here also cover the entire lamp board 21, including the white area in the drawings, to ensure that the lamp board 21 has a transparent effect. And the first light-transmitting hole 24 is set in the clearance of the least two of the LED light beads 23, thereby enabling the lamp board 21 to form a transparent lamp board, and further enabling the display screen body 2 to form said transparent display screen body. In the embodiments of the present disclosure, by designing the connection plate 22 as transparent as well, that is, providing second light-transmitting holes 221 on the connection plate 22 with a same size with the first light-transmitting hole 24 on two sides of the splicing seam, so that while ensuring the firmness of the connection between the two lamp plates 21, it also has good transparency, to enhance the transparent feature and user experience of the said display screen body 2.

Furthermore, in other preferred embodiments of the present disclosure, a VHB adhesive layer 25 is provided between the lamp panel 21 and the connection plate 22, and two opposite surfaces of the VHB adhesive layer 25 are adhered with the lamp panel 21 and the connection plate respectively 22;
the VHB adhesive layer 25 is provided with a third light-transmitting hole 251 with a location corresponding to and a size same with the first light-transmitting hole 24 on two sides of the splicing seam.

Here, by setting the VHB adhesive layer 25 on two sides of the said splicing seam, the connection plate 22 is firmly bonded to the surface of the lamp board 21 away from the side frame 10, so as to make the connection between the two lamp boards 21 more secure. In the embodiments of the present disclosure, by designing the VHB adhesive layer 25 as transparent, that is, providing a third light-transmitting hole 251 on the VHB adhesive layer with a location corresponding to and a size same with the first light-transmitting hole 24 on two sides of the splicing seam, so that while ensuring the sufficient firmness of the connection between the two lamp plates 21, it also has good transparency, to enhance the transparent feature and user experience of the said display screen body 2.

In addition, in other preferred embodiments of the present disclosure, two sides of the splicing seam on a surface of the lamp panel 21 away from the LED light beads 23 are provided with a sinking groove 26 for accommodating the connection plate 22 and the VHB adhesive layer 25, so that a surface of the connection plate 33 away from the VHB adhesive layer 25 is flush with a surface of the lamp panel 21 away from the LED light beads 23.

Since both the connection plate 22 and the VHB adhesive layer 25 have a certain thickness, when they are directly stacked and connected to the two lamp boards 21 on two sides of the splicing seam, they will protrude from the plane where the two lamp boards 21 are located. On the one hand, this will affect the firmness of the connection between the two lamp boards 21. On the other hand, this protruding connection method is prone to delamination, damage, or even board dropping and connection failure. In the embodiments of the present disclosure, by setting the sinking groove 26 on two sides of the splicing seam on the surface of the lamp board 21 away from the LED lamp beads 23, and the size of the sinking grooves 26 on the two lamp boards 21 spliced together is exactly the same as that of the connection plate 22 and the VHB adhesive layer 25, which enables the connection plate 22 and the VHB adhesive layer 25 to be accommodated in the sinking groove 26, and after they are accommodated, the surface of the connection plate 22 away from the VHB adhesive layer 25 is level with the surface of the lamp board 21 away from the LED lamp bead 23. This not only enhances the firmness of the connection between the two lamp boards 21, and can also prevent the phenomenon of delamination damage or even board dropping due to the protruding connection of the connection plate 22, and at the same time improve the flatness of the back of the display screen body 2.

In other preferred embodiments of the present disclosure, the frame body further includes a plurality of adapter corners 13, the adapter corners 13 are provided between two adjacent side frames 10, to connect the two adjacent side frames together 10;
the adapter corners 13 have a mounting portion 131 extending towards a center of the frame body, and the mounting portion 131 is used to mount a power connector and/or a signal connector;
wherein, a size of the power connector and the signal connector on a display surface direction of the display screen body 2 is greater than a width of the side frames 10.

Here, since the signal connector is generally a network cable connector, its specifications and dimensions are usually fixed and relatively large. Meanwhile, the power connector usually needs to be plugged into the power cord and also has a relatively large specification and dimension. At this time, if the power connector and/or the signal connector are set in the middle position of the side frame 10, it will inevitably increase the width of the side frame 10, which makes it very difficult to achieve a display frame with extremely narrow side frames. In this regard, in the embodiments of the present disclosure, an adapter corner 13 is provided between two adjacent side frames 10, to connect the two side frames 10 together. Here, the angle of the adapter corner 13 includes but is not limited to 90 degrees, and the mounting portion 131 is the portion of the adapter corner 13 extending towards a center of the frame body. It generally has a relatively large size in the display surface direction of the display screen body 2, specifically larger than the size of the power connector and the signal connector in the display surface direction of the display screen body 2. Thus, the power connector and/or the signal connector can be installed on the mounting portion 131 without occupying the width of the middle of the side frame 10, which makes it possible to realize a display screen frame with extremely narrow side frames, and the mounting portion 131 located at the connection of the two side frames 10 will not have much impact on the transparency of the display surface inside the frame body, thereby making the transparent display screen have the greatest possible transparency and further enhancing the user experience of the transparent display screen.

It should be noted that there are various combinations of multiple power boards 20 and adapter boards 30 distributed in different side frames 10. As shown in the scheme in FIGs. 1 to 6, since a relatively large amount of electrical energy is required to ensure sufficient brightness, a greater number of power boards 20 are set up, which can handle scenarios with high brightness intensity (including but not limited to outdoor scenarios), and it can also handle scenarios with relatively weak brightness intensity (including but not limited to indoor scenarios).

However, those skilled in the art should understand that, in addition to the above setting methods, the setting methods of the power board 20 and the adapter board 30 can have multiple variations: the power board 20 and the adapter board 30 can be respectively arranged in the two side frames 10 on the opposite side, i.e., in the common quadrilateral structure of the integrated frame 1, there are two pairs of opposite side frames 10, among which the power board 20 and the adapter board 30 are respectively arranged in one pair of opposite side frames 10, on the inner side of the other pair of opposite side frames 10, the power board 20 and the adapter board 30 are not provided, which merely serve to connect and support. Thus, the side frames 10 used for connection and support can be made into extremely narrow side frames, which in turn enables the display screen to have better transparency. Of course, the power board 20 and the adapter board 30 can also be respectively set in two adjacent side frames 10, while the other side frames 10 may not be set with the power board 20 and the adapter board 30, and only serve to connect and support. These side frames 10 used for connection and support can be made into extremely narrow side frames. It can also make the display screen have good transparency. Or if the spatial structure of a side frame 10 on one side conforms to the placement requirements of the power board 20 and the adapter board 30, the power board 20 and the adapter board 30 can be placed within the side frame 10 on the same side, while the other side frames 10 may not be set with the power board 20 and the adapter board 30, and only serve to connect and support. The side frames 10 used for connection and support can be made into extremely narrow side frames, thereby enabling the display screen to have better transparency.

It is understandable that in the above-mentioned deformed setting method, there is no need to set up a large number of power boards 20. This is mainly related to design requirements and technological development. For example, if the designed transparent screen is only used in scenarios with relatively weak brightness and intensity, the required power is relatively small at this time, and there is no need to set up such a large number of power boards 20. Or, with the significant development of future power supply technology, sufficient electrical energy can be provided with a very small power supply, and there is no need to set up such a large number of power boards. Of course, the reasons mentioned above are diverse, but no matter how they change, they all fall within the scope of disclosure of the present disclosure.

It is finally to be noted that the above embodiments are adopted not to limit but only to describe the technical solutions of the present disclosure. Although the present disclosure has been described with reference to the abovementioned embodiments in detail, those of ordinary skill in the art should know that modifications may still be made to the technical solutions recorded in each embodiment or equivalent replacements may be made to part of technical features therein. These modifications or replacements do not make the essences of the corresponding technical solutions depart from the spirit and scope of the technical solutions of each embodiment of the present disclosure.

## Claims

1. An integrated frame, with a display screen body arranged on a side of the integrated frame, wherein the integrated frame comprises:
a frame body, comprising a plurality of side frames connected end to end in sequence, wherein the side frames are not protruding from an edge where the display screen body is in contact with the side frames;
a power board, being coupled to the display screen body; and
an adapter board, being coupled to both the power board and the display screen body, wherein the power board and the adapter board are arranged inside the side frames respectively.

2. The integrated frame according to claim 1, wherein the plurality of side frames comprises one first side frame and a plurality of second side frames;
the adapter board is arranged inside the first side frame;
the power board is disassembled into a plurality of power modules being coupled together, and each of the second side frames is provided with at least one power module.

3. The integrated frame according to claim 1, wherein the plurality of side frames is connected end to end in sequence, to enclose the frame body with a hollow interior, a side of the display screen body away from a display surface of the display screen body is free from a support rod, a grille and other rod members connected on the side frames.

4. The integrated frame according to claim 1, wherein the frame body further comprises a plurality of adapter corners, the adapter corners are provided between two adjacent side frames, to connect the two adjacent side frames together;
the adapter corners have a mounting portion extending towards a center of the frame body, and the mounting portion is used to mount a power connector and/or a signal connector;
wherein, a size of the power connector and the signal connector on a display surface direction of the display screen body is greater than a width of the side frames.

5. The integrated frame according to claim 1, wherein the side frames are provided an accommodation groove, and both the power board and the adapter board are provided at least one;
the power board or the adapter board is accommodated one-to-one with the accommodation groove, or the power board and the adapter board are accommodated in one accommodation groove at the same time.

6. The integrated frame according to claim 5, wherein a side of the side frames facing the display screen body is provided with a wire accommodation groove, the wire accommodation groove is in communication with the accommodation groove, and a coupling wire is accommodated in the wire accommodation groove.

7. The integrated frame according to claim 5, wherein the power board and the adapter board are arranged in the accommodation groove without protruding from the side frames.

8. The integrated frame according to claim 5, wherein the accommodation groove is located on a side of the side frames facing an inner side of the integrated frame; or
the accommodation groove is located on a side of the side frames facing an outer side of the integrated frame; or
the accommodation groove is located inside the side frames; or
the accommodation groove is located on a side of the side frames facing the display screen body; or
the accommodation groove is located on a side of the side frames away the display screen body.

9. The integrated frame according to claim 5, further comprising:
a cover plate, being covered at an opening of the accommodation groove.

10. The integrated frame according to claim 1, wherein the power board and the adapter board are located at different side frames.

11. The integrated frame according to claim 5, further comprising:
a power output connector and a power input connector matching each other, and a signal output connector and a signal input connector matching each other;
both the power output connector and the power input connector are coupled to the power board;
both the signal output connector and the signal input connector are coupled to the adapter board;
the power output connector and the power input connector are located two ends of the side frames respectively;
the signal output connector and the signal input connector are located two ends of the side frames respectively;
the side frame being provided with the power output connector or the power input connector is arranged opposite to the side frame being provided with signal output connector or the signal input connector.

12. The integrated frame according to claim 5, wherein the integrated frame is integrally formed and is made of metal material.

13. A transparent screen, comprising:
an integrated frame and a transparent display screen body being located at a side of the integrated frame; wherein,
the transparent display screen body is coupled with the integrated frame, and the integrated frame comprises:
a frame body, comprising a plurality of side frames connected end to end in sequence, wherein the side frames are not protruding from an edge where the display screen body is in contact with the side frames;
a power board, being coupled to the display screen body; and
an adapter board, being coupled to both the power board and the display screen body, wherein the power board and the adapter board are arranged inside the side frames respectively.

14. The transparent screen according to claim 13, wherein the display screen body comprises one lamp panel, an outer edge of the lamp panel away from its display surface is connected to the frame body.

15. The transparent screen according to claim 13, wherein the display screen body comprises at least two lamp panels being tiled and spliced together and being connected to the side frames, and a surface of the display screen body away from its display surface is provided a plurality of connection plates;
the connection plates are provided at a splicing seam of two lamp panels and are used to connect two adjacent lamp panels together.

16. The transparent screen according to claim 15, wherein a surface of the lamp panel away from the side frames is provided with a plurality of LED light beads being arranged in an array, the lamp panel is further provided with a plurality of first light-transmitting holes, the first light-transmitting holes are arranged inside a clearance of at least two LED light beads;
the connection plate is provided with a second light-transmitting hole with a location corresponding to and a size same with the first light-transmitting hole on two sides of the splicing seam.

17. The transparent screen according to claim 16, wherein a VHB adhesive layer is provided between the lamp panel and the connection plate, and two opposite surfaces of the VHB adhesive layer are adhered with the lamp panel and the connection plate respectively;
the VHB adhesive layer is provided with a third light-transmitting hole with a location corresponding to and a size same with the first light-transmitting hole on two sides of the splicing seam.

18. The transparent screen according to claim 17, wherein two sides of the splicing seam on a surface of the lamp panel away from the LED light beads are provided with a sinking groove for accommodating the connection plate and the VHB adhesive layer, so that a surface of the connection plate away from the VHB adhesive layer is flush with a surface of the lamp panel away from the LED light beads.

19. The transparent screen according to claim 13, wherein a surface of the display screen body away from the side frames comprises an arear being attached with the side frames, a plurality of LED light beads is arranged in the area in an array.

20. The transparent screen according to claim 13, wherein the plurality of side frames comprises one first side frame and a plurality of second side frames;
the adapter board is arranged inside the first side frame;
the power board is disassembled into a plurality of power modules being coupled together, and each of the second side frames is provided with at least one power module.

21. The transparent screen according to claim 13, wherein the plurality of side frames is connected end to end in sequence, to enclose the frame body with a hollow interior, a side of the display screen body away from a display surface of the display screen body is free from a support rod, a grille and other rod members connected on the side frames.

22. The transparent screen according to claim 13, wherein the frame body further comprises a plurality of adapter corners, the adapter corners is provided between two adjacent side frames, to connect the two adjacent side frames together;
the adapter corners have a mounting portion, and the mounting portion is used to mount a power connector and/or a signal connector;
wherein, a size of the power connector and the signal connector on a display surface direction of the display screen body is greater than a width of the side frames.

23. The transparent screen according to claim 13, wherein the side frames are provided an accommodation groove, and both the power board and the adapter board are provided at least one;
the power board or the adapter board is accommodated one-to-one with the accommodation groove, or the power board and the adapter board are accommodated in one accommodation groove at the same time.

24. The transparent screen according to claim 23, wherein a side of the side frames facing the display screen body is provided with a wire accommodation groove, the wire accommodation groove is in communication with the accommodation groove, and a coupling wire is accommodated in the wire accommodation groove.

25. The transparent screen according to claim 23, wherein the power board and the adapter board are arranged in the accommodation groove without protruding from the side frames.

26. The transparent screen according to claim 23, wherein the accommodation groove is located on a side of the side frames facing an inner side of the integrated frame; or
the accommodation groove is located on a side of the side frames facing an outer side of the integrated frame; or
the accommodation groove is located inside the side frames; or
the accommodation groove is located on a side of the side frames facing the display screen body; or
the accommodation groove is located on a side of the side frames away the display screen body.

27. The transparent screen according to claim 23, further comprising:
a cover plate, being covered at an opening of the accommodation groove.

28. The transparent screen according to claim 13, wherein the power board and the adapter board are located at different side frames.

29. The transparent screen according to claim 23, further comprising:
a power output connector and a power input connector matching each other, and a signal output connector and a signal input connector matching each other;
both the power output connector and the power input connector are coupled to the power board;
both the signal output connector and the signal input connector are coupled to the adapter board;
the power output connector and the power input connector are located two ends of the side frames respectively;
the signal output connector and the signal input connector are located two ends of the side frames respectively;
the side frame being provided with the power output connector or the power input connector is arranged opposite to the side frame being provided with signal output connector or the signal input connector.

30. The transparent screen according to claim 23, wherein the integrated frame is integrally formed and is made of metal material.
